# EUROPEAN PATENT APPLICATION

(11) **EP 1 830 394 A1**
(43) Date of publication of application: **05.09.2007**
(21) Application number: 05811657.5
(22) Date of filing: 02.12.2005
(51) Int. Cl.: H01L 21/027, G02B 7/02, G03F 7/20

(54) **EXPOSURE APPARATUS, EXPOSURE METHOD AND DEVICE MANUFACTURING METHOD**

(30) Priority: 02.12.2004 JP 2004349729
(71) Applicant: NIKON CORPORATION, Tokyo 100-8331 (JP)
(72) Inventor: OKADA, Takaya c/o Nikon Corporation, IP Dept., Tokyo 1008331 (JP)
(74) Representative: Viering, Jentschura & Partner
(86) International application number: PCT/JP2005/022193
(87) International publication number: WO 2006/059720

(57) **Abstract**

An exposure apparatus (EX) irradiates a substrate (W) with exposure light (EL) via a projection optical system (PL) to expose the substrate W). The projection optical system (PL) has a first optical element (LS1) nearest to an image plane of the projection optical system (PL) and a second optical element (LS2) second nearest to the image plane after the first optical element (LS1). The exposure apparatus (EX) includes: an immersion mechanism (2) that fills a first space (K1) on a bottom surface (T3) side of the second optical element (LS2) with a liquid; a gas substitution apparatus (3) that fills a second space (K2) on an upper surface (T4) side of the second optical element (LS2) with a gas; and a control apparatus (CONT) that adjusts a pressure difference between a pressure of the liquid (LQ) in the first space (K1) and a pressure of the gas in the second space (K2).

## Description

### TECHNICAL FIELD

The present invention relates to an exposure apparatus, exposure method, and device manufacturing method that expose a substrate via a projection optical system.

Priority is claimed on Japanese Patent Application No. 2004-349729, filed on December 2, 2004, the contents of which are incorporated herein by reference.

### BACKGROUND ART

In the photolithography process which is one manufacturing process for micro devices such as semiconductor devices and liquid crystal display devices, an exposure apparatus is used which exposes a pattern formed on a mask onto a photosensitive substrate. This exposure apparatus has a mask stage for supporting the mask and a substrate stage for supporting the substrate, and exposes a pattern on the mask onto the substrate via a projection optical system while sequentially moving the mask stage and the substrate stage.

In the manufacture of a micro device, in order to increase the density of the device, it is necessary to make the pattern formed on the substrate fine. In order to address this necessity, even higher resolution of the exposure apparatus is desired.

As one means for realizing this higher resolution, there is proposed a liquid immersion exposure apparatus as disclosed in Patent Document 1 below, in which a liquid is filled between the projection optical system and the substrate to form a liquid immersion region, and an exposure process is performed via the liquid in the liquid immersion region.

Patent Document 1: PCT International Patent Publication No. WO 99/49504

### DISCLOSURE OF INVENTION

### PROBLEMS TO BE SOLVED BY THE INVENTION

In a liquid immersion exposure apparatus, a predetermined space in the optical path of exposure light is filled with a liquid while the rest of the space is filled with a gas. There is a possibility that force (pressure) by the liquid or the gas may slightly deform or move an optical element placed in the optical path space. If the optical element is deformed or moved, there is a possibility that exposure accuracy or measurement accuracy may be degraded.

The present invention has been achieved in view of such circumstances, and has a purpose to provide an exposure apparatus, exposure method, and device manufacturing method that can favorably maintain exposure accuracy.

### MEANS FOR SOLVING THE PROBLEM

A first aspect of the present invention provides an exposure apparatus that irradiates a substrate with exposure light via a projection optical system to expose the substrate, in which the projection optical system has a first optical element nearest to an image plane of the projection optical system and a second optical element second nearest to the image plane after the first optical element, and the second optical element has a first surface that faces the first optical element and a second surface on the opposite side of the first surface, the exposure apparatus including: an immersion mechanism that fills a first space on the first surface side of the second optical element with a liquid; a gas supply mechanism that fills a second space on the second surface side of the second optical element with a gas; and an adjustment mechanism that adjusts a pressure difference between a pressure of the liquid in the first space and a pressure of the gas in the second space.

According to the first aspect of the present invention, the adjustment mechanism adjusts the pressure difference between the pressure of the liquid in the first space and the pressure of the gas in the second space. Consequently, the occurrence of an unfavorable situation where the second optical element is deformed or moved by the pressure of the liquid or gas can be suppressed. Therefore, exposure accuracy or measurement accuracy can be favorably maintained.

A second aspect of the present invention provides a device manufacturing method that uses the exposure apparatus of the above-mentioned aspect.

According to the second aspect of the present invention, a device with desired performance can be provided by use of the exposure apparatus with suppressed degradation of exposure accuracy.

A third aspect of the present invention provides an exposure method that irradiates a substrate with exposure light via a projection optical system to expose the substrate, in which the projection optical system includes a first optical element nearest to an image plane of the projection optical system and a second optical element second nearest to the image plane after the first optical element, the second optical element has a first surface that faces the first optical element and a second surface on the opposite side of the first surface, and a pressure difference is adjusted between a pressure of a liquid filled in a first space on the first surface of the second optical element and a pressure of a gas in a second space on the second surface of the second optical element.

According to the third aspect of the present invention, by adjusting the pressure difference between the pressure of the liquid in the first space and the pressure of the gas in the second space, the occurrence of an unfavorable situation where the second optical element is deformed or moved by the pressure of the liquid or gas can be suppressed. Therefore, exposure accuracy or measurement accuracy can be favorably maintained.

A fourth aspect of the present invention provides a device manufacturing method that uses the exposure method of the above-mentioned aspect.

According to the fourth aspect of the present invention, degradation in exposure accuracy can be suppressed. Therefore, a device with desired performance can be provided.

### EFFECTS OF THE INVENTION

According to the present invention, a substrate can be exposed while exposure accuracy or measurement accuracy is favorably maintained. Therefore, a device with desired performance can be manufactured.

### BRIEF DESCRIPTION OF THE DRAWINGS

FIG. 1 is a schematic block diagram showing an embodiment of an exposure apparatus.
FIG. 2 is an enlarged cross-sectional view of the main part of the exposure apparatus.
FIG. 3 is a drawing showing another example of the detector for detecting leakage of a liquid.
FIG. 4 is a drawing showing another example of the first detector for detecting pressure of a liquid in the first space.
FIG. 5 is a flowchart showing an example of an exposure method.
FIG. 6 is a drawing for explaining how the liquid fluctuates in pressure.
FIG. 7 is a schematic view for explaining pressure applied to an optical element.
FIG. 8 is a flowchart showing an example of manufacturing steps for a micro device.

### DESCRIPTION OF THE REFERENCE SYMBOLS

1: FIRST IMMERSION MECHANISM; 2: SECOND IMMERSION MECHANISM; 3: GAS SUBSTITUTION APPARATUS (GAS SUPPLY MECHANISM); 71: FIRST NOZZLE MEMBER; 72: SECOND NOZZLE MEMBER; 101: FIRST DETECTOR; 102: SECOND DETECTOR; CONT: CONTROL APPARATUS (ADJUSTMENT MECHANISM); EL: EXPOSURE LIGHT; EX: EXPOSURE APPARATUS; G: GAS; K1: FIRST SPACE; K2: SECOND SPACE; LC: IMAGING CHARACTERISTIC ADJUSTMENT APPARATUS; LQ: LIQUID; LS1: FIRST OPTICAL ELEMENT; LS2: SECOND OPTICAL ELEMENT; MRY: MEMORY APPARATUS; PL: PROJECTION OPTICAL SYSTEM; T3: BOTTOM SURFACE (FIRST SURFACE); T4: UPPER SURFACE (SECOND SURFACE); W: SUBSTRATE

### BEST MODE FOR CARRYING OUT THE INVENTION

Hereunder is a description of embodiments of the present invention with reference to the drawings. However the present invention is not limited to this description.

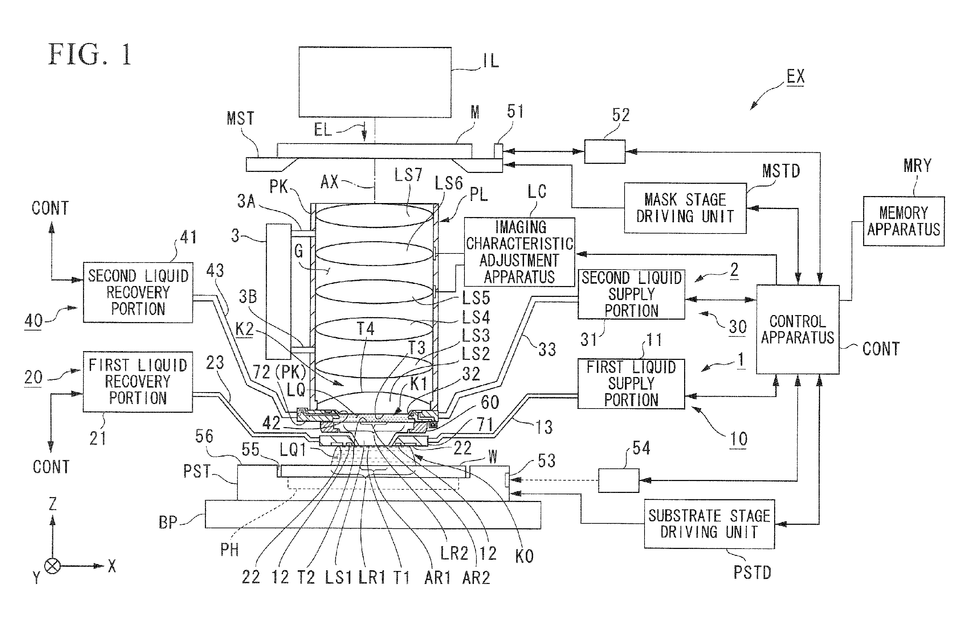

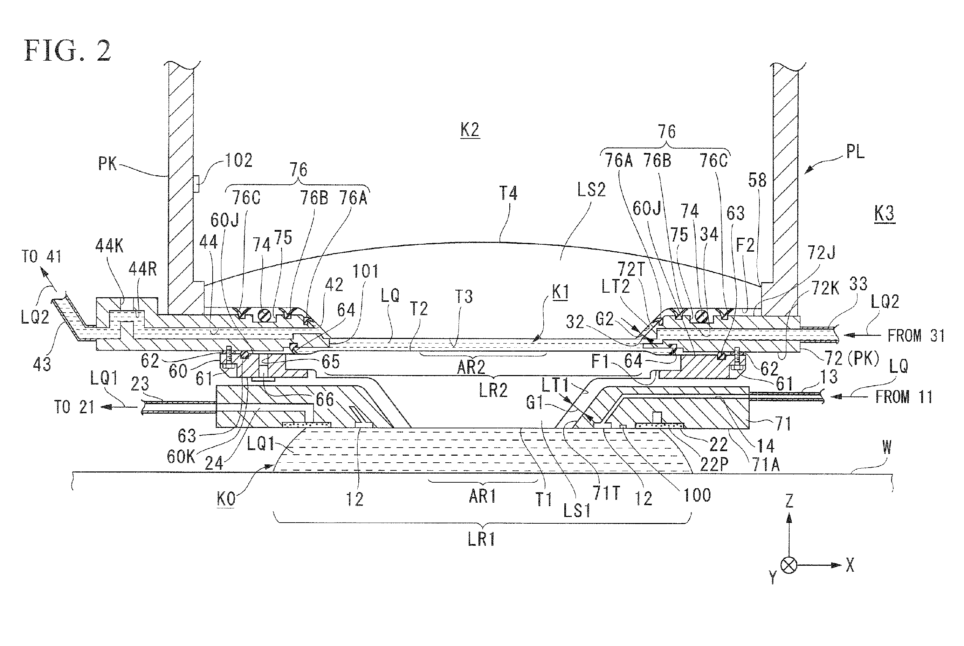

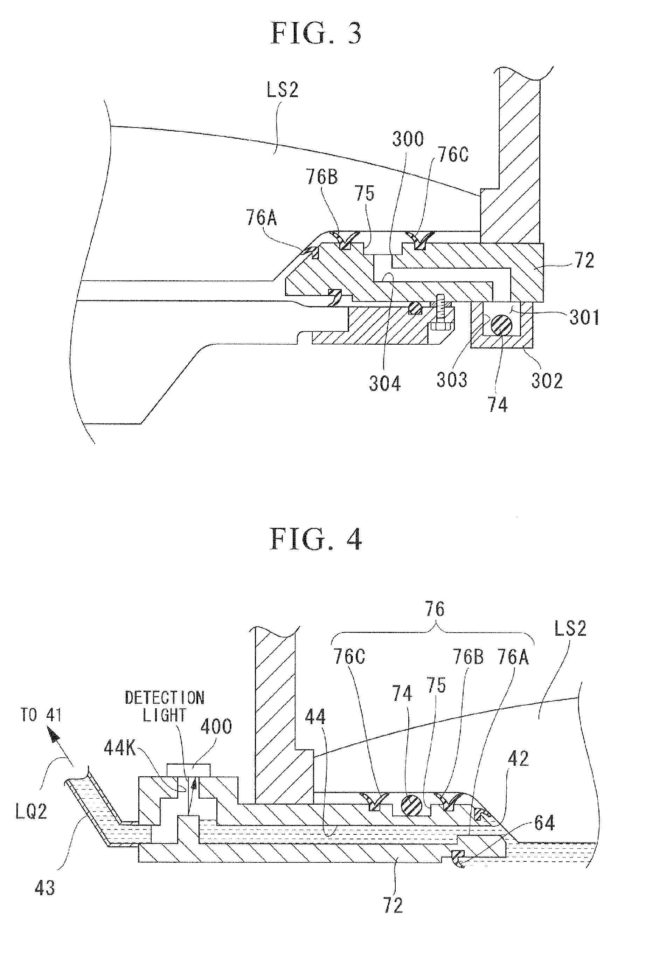

FIG. 1 is a schematic block diagram showing an exposure apparatus EX according to one embodiment. In FIG. 1, the exposure apparatus EX includes: a mask stage MST capable of moving while holding a mask M, a substrate stage PST capable of moving while holding a substrate W, an illumination optical system IL for illuminating a mask M held on the mask stage MST with exposure light EL, a projection optical system PL for projecting a pattern of the mask M illuminated by the exposure light EL onto the substrate W held on the substrate stage PST, and a control apparatus CONT for controlling the operation of the whole exposure apparatus EX. The projection optical system PL includes a plurality of optical elements LS1 to LS7. Among the optical elements LS1 to LS7, the first optical element LS1 nearest to the image plane of the projection optical system PL is held by a holding member (lens cell) 60, while the optical elements LS2 to LS7 other than the optical element LS 1 are held in a barrel PK. To the control apparatus CONT, there is connected a memory apparatus MRY in which various information on the exposure process is stored.

The exposure apparatus EX of the present embodiment is an immersion exposure apparatus to which an immersion method is applied for substantially shortening the exposure wavelength and improving the resolution, and also substantially expanding the depth of focus. It includes a first immersion mechanism 1 that fills a space K0 with a liquid LQ, the space K0 being formed between the substrate W and a bottom surface T1 of the first optical element LS1 nearest to the image plane of the projection optical system PL among the optical elements LS1 to LS7 that constitute the projection optical system PL. The substrate W is arranged to the image plane side of the projection optical system PL. The first optical element LS1 has the bottom surface T1 facing the surface of the substrate W and an upper surface T2 on the opposite side of the bottom surface T1. The surface of the substrate W is arranged so as to face the bottom surface T1 of the first optical element LS1. The first immersion mechanism 1 includes: an annular-shaped first nozzle member 71 provided above the substrate W (the substrate stage PST) so as to surround a side surface of the first optical element LS1; a first liquid supply mechanism 10 that supplies the liquid LQ to the space K0 between the bottom surface T1 of the first optical element LS1 and the substrate W via a supply port 12 provided in the first nozzle member 71; and a first liquid recovery mechanism 20 that recovers the liquid LQ in the space K0 via a collection port 22 provided in the first nozzle member 71. Operation of the first immersion mechanism 1 is controlled by the control apparatus CONT.

The exposure apparatus EX includes a second immersion mechanism 2 that fills a space K1 with liquid LQ, the space K1 being formed between the first optical element LS 1 and the second optical element LS2 that is second nearest to the image plane of the projection optical system PL after the first optical element LS1. The second optical element LS2 is arranged above the first optical element LS 1. The second optical element LS2 has a bottom surface T3 facing the upper surface T2 of the first optical clement LS and an upper surface T4 on the opposite side of the bottom surface T3. The second immersion mechanism 2 includes: an annular-shaped second nozzle member 72 provided above the first optical element LS 1 so as to surround a side surface of the second optical element LS2; a second liquid supply mechanism 30 that supplies the liquid LQ to the space K1 between the bottom surface T3 of the second optical element LS2 and the upper surface T2 of the first optical element LS1 via a supply port 32 provided in the second nozzle member 72; and a second liquid recovery mechanism 40 that recovers the liquid LQ in the space K1 via a collection port 42 provided in the second nozzle member 72. Operation of the second immersion mechanism 2 is controlled by the control apparatus CONT.

The exposure apparatus EX further includes a gas substitution apparatus (gas supply mechanism) 3 that fills a space K2 inside the barrel PK with a predetermined gas G. The space K2 is a space surrounded by an inner wall of the barrel PK, the upper surface T4 of the second optical element LS2, and a bottom surface of the optical element LS7. Other optical elements LS3 to LS6 are arranged in this space such that the spaces between the respective optical elements can be in pneumatic communication with each other. The second optical element LS2 and the optical element LS7 are configured such that circulation of a gas is suppressed with respect to an atmosphere outside the barrel PK. The gas substitution apparatus 3 is connected to the space K2. it includes a supply pipe 3A for supplying the gas G to the space K2 and a recovery pipe 3B for recovering the gas G in the space K2. The space inside the barrel PK is substantially hermetically sealed. The gas substitution apparatus 3 maintains the space K2 in a predetermined gas environment. In this embodiment, the gas substitution apparatus 3 fills the space K2 with an inert gas such as nitrogen. Operation of the gas substitution apparatus 3 is controlled by the control apparatus CONT.

Here, in the following description, the space K0 between the bottom surface T1 of the first optical element LS 1 and the surface of the substrate W is appropriately referred to as "the image plane side space K0." The space K1 between the upper surface T2 of the first optical element LS 1 and the bottom surface T3 of the second optical element LS2 is appropriately referred to as "the first space K1." The space K2, in the space inside the barrel PK, on the upper surface T4 side of the second optical element LS2 is appropriately referred to as "the second space K2."

In this embodiment, the image plane side space K0 between the first optical element LS1 and the substrate W, the first space K 1 between the upper surface T2 of the first optical element LS1 and the bottom surface T3 of the second optical element LS2, and the second space K2 on the upper surface T4 side of the second optical element LS2 are spaces independent of each other. Inflow and outflow of the liquid LQ from/to one of the image plane side space K0 and the first space K1 to/from the other thereof are suppressed. Moreover, inflow of the gas G in the second space K2 to the first space K1 and inflow of the liquid LQ in the first space K1 to the second space K2 are also suppressed.

The control apparatus CONT is capable of independently performing: supply operation and recovery operation of the liquid LQ to/from the image plane side space K0 by the first immersion mechanism 1; supply operation and recovery operation of the liquid LQ to/from the first space K1 by the second immersion mechanism 2; and supply operation and recovery operation of the gas G to/from the second space K2 by the gas substitution apparatus 3.

Furthermore, the control apparatus CONT is capable of adjusting a pressure P₁ of the liquid LQ in the first space K1 on the bottom surface T3 side of the second optical element LS2 by controlling a supply amount per unit time of the liquid LQ to the first space K1 via the supply port 32 of the second immersion mechanism 2 and a recovery amount per unit time of the liquid LQ in the first space K1 via the collection port 42.

Furthermore, the control apparatus CONT is capable of adjusting a pressure P₂ of the gas G in the second space K2 on the upper surface T4 side of the second optical element LS2 by controlling a supply amount per unit time of the gas G to the second space K2 via the supply pipe 3A of the gas substitution apparatus 3 and a recovery amount per unit time of the gas G in the second space K2 via the recovery pipe 3B.

The control apparatus CONT is capable of adjusting a pressure difference △P between the pressure P₁ of the liquid LQ in the first space K1 and the pressure P₂ of the gas G in the second space K2 by using the second immersion mechanism 2 to adjust the pressure P₁ of the liquid LQ in the first space K1 and at the same time by using the gas substitution apparatus 3 to adjust the pressure P₂ of the gas G in the second space K2.

The exposure apparatus EX, at least during exposure of the pattern image of the mask M onto the substrate W, uses the first immersion mechanism 1 to fill the space between the first optical element LS 1 and the substrate W arranged on the image plane side thereof with the liquid LQ, thus forming a first immersion region LR1, and at the same time uses the second immersion mechanism 2 to fill the space between the first optical element LS 1 and the second optical element LS2 with the liquid LQ, thus forming a second immersion region LR2. In this embodiment, the exposure apparatus EX adopts a local liquid immersion method that locally forms a first immersion region LR1 which is greater than a projection region AR1, and smaller than the substrate W, on a region of one part of the substrate W which includes the projection region AR1 of the projection optical system PL. Furthermore, in this embodiment, the exposure apparatus EX forms a second immersion region LR2 on an area of the liquid LQ, of the upper surface T2 of the first optical element LS1, that includes a region AR2 through which the exposure light EL passes. The exposure apparatus EX irradiates the substrate W via the projection optical system PL, the liquid LQ in the second immersion region LR2, and the liquid LQ in the first immersion region LR1, with the exposure light EL that has passed through the mask M, for projection-exposing the pattern of the mask M onto the substrate W.

In this embodiment, the first immersion region LR1 is sometimes described to be formed on the substrate P. However, it is possible that the first immersion region LR1 is formed, on the image plane side of the projection optical system PL, on an object arranged at a position facing the first optical element LS1, for example, on the upper surface of the substrate stage PST.

This embodiment will be described as a case where a scanning type exposure apparatus is used (a so-called scanning stepper) as the exposure apparatus EX, in which while synchronously moving the mask M and the substrate W in the scanning direction, the pattern formed on the mask M is exposed onto the substrate W. In the following description, the direction that coincides with an optical axis AX of the projection optical system PL is made the Z axis direction, the synchronous movement direction (the scanning direction) of the mask M and the substrate W in a plane perpendicular to the Z axis is made the X axis direction, and the direction perpendicular to the Z axis direction and the X axis direction (the non-scanning direction) is made the Y axis direction. Furthermore, rotation (inclination) directions about the X axis, the Y axis and the Z axis, are made the θX, the θY, and the θZ directions respectively.

The illumination optical system IL has a light source for exposure that emits the exposure light EL, an optical integrator for making the luminance distribution of the exposure light EL emitted from the light source for exposure uniform, a condenser lens for condensing the exposure light EL from the optical integrator, a relay lens system, a field stop for setting an illumination area on the mask M formed by the exposure light EL, etc. A specified illumination area on the mask M is illuminated, by the illumination optical system IL, with the exposure light EL having a uniform luminance distribution. For the exposure light EL emitted from the light source for exposure, for example emission lines (g line, h line, i line), emitted from a mercury lamp, deep ultraviolet beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm), may be used. In this embodiment, the ArF excimer laser beam is used.

In this embodiment, pure water is used as the liquid LQ supplied from the first liquid supply mechanism 10 and as the liquid LQ supplied from the second liquid supply mechanism 30. That is, in this embodiment, the liquid LQ in the image plane side space K0 and the liquid LQ in the first space K1 are the same liquid. Pure water is capable of transmitting not only an ArF excimer laser beam but also, for example, emission lines (g line, h line, or i line) emitted from a mercury lamp and deep ultraviolet beams (DUV light beam) such as the KrF excimer laser beam (wavelength: 248 nm).

The mask stage MST is movable while holding the mask M. The mask stage MST holds the mask M by vacuum attraction (or electrostatic attraction). The mask stage MST, while holding the mask M, is two-dimensionally movable in a plane perpendicular to the optical axis AX of the projection optical system PL, i.e., in the XY-plane, and is finely rotatable in the θZ direction, by means of drive from a mask stage driving unit MSTD including, e.g., a linear motor controlled by the control apparatus CONT. The mask stage MST is movable in the X axis direction at a designated scanning speed and has a travel stroke in the X axis direction long enough to allow the entire surface of the mask M to transverse at least the optical axis AX of the projection optical system PL.

A movement mirror 51 is provided on the mask stage MST. A laser interferometer 52 is provided at a position facing the movement mirror 51. The two-dimensional position and rotation angle in the θZ (including the rotation angles in the θX and θY directions, as the case may be) direction of the mask M on the mask stage MST are measured by the laser interferometer 52 in real time. The measurement results from the laser interferometer 52 are outputted to the control apparatus CONT. The control apparatus CONT drives the mask stage driving unit MSTD based on the measurement results from the laser interferometer 52 so as to control the position of the mask M held on the mask stage MST.

The projection optical system PL is for projecting a pattern of the mask M onto the substrate W at a predetermined projection magnification β and is constituted by the optical elements LS1 to LS7. The holding member (lens cell) 60 for holding the first optical element LS 1 is joined to the second nozzle member 72 of the second immersion mechanism 2. The second nozzle member 72 is joined to the lower end portion of the barrel PK. In this embodiment, the second nozzle member 72 is substantially integral with the barrel PK. In other words, the second nozzle member 72 forms a part of the barrel PK. However, the second nozzle member 72 can be a member independent of the barrel PK, and the second nozzle member 72 can be supported by a predetermined support mechanism different from the barrel PK. Alternatively, the barrel PK can be assembled from a plurality of split barrels (sub barrels). In this embodiment, the projection optical system PL is a reduction system having the projection magnification β of, for example, 1/4, 1/5, or 1/8. Alternatively, the projection optical system PL may be an equal system or a magnifying system.

As described above, in the space inside the barrel PK, the second space K2 on the upper surface T4 side of the second optical element LS2 is filled with an inert gas such as nitrogen by the gas substitution apparatus 3. Alternatively, the second space K2 may be filled with helium, argon, dry air, etc. In the case of using a vacuum ultraviolet light beam as the exposure light EL, when absorptive matters furnished with a strong absorptive properties with respect to a light beam in such a wavelength region, such as oxygen molecules, water molecules, carbon dioxide molecules, and organic matters, are present in the optical path space through which the exposure light EL passes, the exposure light EL is absorbed by the absorptive matters and thus unable to reach the substrate W with sufficient light intensity. To address this, the second space K2 inside the barrel PK through which the exposure light EL passes is substantially hermetically sealed to prevent the absorptive matters from flowing in from the outside, and also the second space K2 is filled with an inert gas. Thus, the exposure light EL is allowed to reach the substrate W with sufficient light intensity.

The projection optical system PL is provided with an imaging characteristic adjustment apparatus LC as disclosed in, for example, Japanese Unexamined Patent Publication, First Publication No. S60-78454 and Japanese Unexamined Patent Publication, First Publication No. H11-195602. The imaging characteristic adjustment apparatus LC is capable of adjusting an imaging characteristic such as the image plane position of the projection optical system PL, etc. by driving a specific optical element of the optical elements LS1 to LS7 that constitute the projection optical system PL.

The substrate stage PST is capable of moving the substrate holder PH for holding the substrate W. The substrate holder PH holds the substrate W by, for example, vacuum attraction. A recess portion 55 is provided on the substrate stage PST. The substrate holder PH for holding the substrate W is arranged in the recess portion 55. The upper surface 56 other than the recess portion 55 of the substrate stage PST is flat such that it is at substantially the same height as (flush with) a surface of the substrate W held in the substrate holder PH. The substrate stage PST, while holding the substrate W via the substrate holder PH, is two-dimensionally movable, on the base BP, in the XY-plane, and is finely rotatable in the θZ direction, by means of drive from a substrate stage driving unit PSTD including, for example, a linear motor controlled by the control apparatus CONT. Furthermore, the substrate stage PST is also movable in the Z axis direction and in the θX and θY directions.

A movement mirror 53 is provided on a side surface of the substrate stage PST. A laser interferometer 54 is provided at a position facing the movement mirror 53. The two-dimensional position and rotation angle of the substrate W on the substrate stage PST are measured by the laser interferometer 54 in real time. Furthermore, the exposure apparatus EX includes a focus leveling detection system (not shown in the figure) that detects position information of the surface of the substrate W supported by the substrate stage PST. As for a focus leveling detection system, an oblique incidence type that shines detection light obliquely onto the surface of the substrate W, a type that uses a capacitance type sensor, or other types may be adopted. The focus leveling detection system detects, via or not via the liquid LQ, position information in the Z axis direction of the surface of the substrate W and inclination information in the θX and θY directions of the substrate W.

The measurement results from the laser interferometer 54 are outputted to the control apparatus CONT. The detection results from the focus leveling detection system are also outputted to the control apparatus CONT. The control apparatus CONT drives the substrate stage driving unit PSTD based on the detection results from the focus leveling detection system so as to control the focus position and inclination angles of the substrate W such that the surface of the substrate W is adjusted to match the image plane of the projection optical system PL by means of an autofocus system and an autoleveling system, and at the same time controls the position of the substrate W in the X axis and Y axis directions based on the measurement results from the laser interferometer 54.

Next, the first immersion mechanism 1 and the second immersion mechanism 2 will be described. The first liquid supply mechanism 10 of the first immersion mechanism 1 is for supplying the liquid LQ to the image plane side space K0 between the first optical element LS1 of the projection optical system PL and the substrate W. It includes a first liquid supply portion 11 that can send out the liquid LQ and a first supply pipe 13 one end of which is connected to the first liquid supply portion 11. The other end of the first supply pipe 13 is connected to the first nozzle member 71. The first liquid supply portion 11 at least includes a tank that stores the liquid LQ, a pressurizing pump, a temperature-adjusting mechanism that adjusts the temperature of the liquid LQ to be supplied, and a filter unit that removes foreign matter (including a bubble) in the liquid LQ. Operation of the first liquid supply portion 11 is controlled by a control apparatus CONT. It is to be noted that the first liquid supply mechanism 10 of the exposure apparatus EX need not include all of the tank, pressurizing pump, temperature-adjusting apparatus, filter unit, etc. but at least some of them may be substituted by equipment of the factory or the like where the exposure apparatus EX is installed.

The first liquid recovery mechanism 20 of the first immersion mechanism 1 is for recovering the liquid LQ on the bottom surface T1 side of the first optical element LS1. It includes a first liquid recovery portion 21 that can recover the liquid LQ and a first recovery pipe 23 one end of which is connected to the first liquid recovery portion 21. The other end of the first recovery pipe 23 is connected to the first nozzle member 71. The first liquid recovery portion 21 includes, for example, a vacuum system (suction apparatus) such as a vacuum pump, a gas-liquid separator that separates a gas from the recovered liquid LQ, and a tank that stores the recovered liquid LQ. Operation of the first liquid recovery portion 21 is controlled by a control apparatus CONT. It is to be noted that the first liquid recovery mechanism 20 of the exposure apparatus EX need not include all of the vacuum system, gas-liquid separator, tank, etc. but at least some of them may be substituted by equipment of the factory or the like where the exposure apparatus EX is installed.

The second liquid supply mechanism 30 of the second immersion mechanism 2 is for supplying the liquid LQ to the first space K1 between the second optical element LS2 and the first optical element LS1 of the projection optical system PL. It includes a second liquid supply portion 31 that can send out the liquid LQ and a second supply pipe 33 one end of which is connected to the second liquid supply portion 31. The other end of the second supply pipe 33 is connected to the second nozzle member 72. The second liquid supply portion 31 at least includes a tank that stores the liquid LQ, a pressurizing pump, a temperature-adjusting mechanism that adjusts the temperature of the liquid LQ to be supplied, and a filter unit that removes foreign matter (including a bubble) in the liquid LQ. Operation of the second liquid supply portion 31 is controlled by a control apparatus CONT. It is to be noted that the second liquid supply mechanism 30 of the exposure apparatus EX need not include all of the tank, pressurizing pump, temperature-adjusting apparatus, filter unit, etc. but at least some of them may be substituted by equipment of the factory or the like where the exposure apparatus EX is installed.

The second liquid recovery mechanism 40 of the second immersion mechanism 2 is for recovering the liquid LQ in the first space K1 between the second optical element LS2 and the first optical element LS1 of the projection optical system PL. It includes; a second liquid recovery portion 41 that can recover the liquid LQ; and a second recovery pipe 43 one end of which is connected to the second liquid recovery portion 41. The other end of the second recovery pipe 43 is connected to the second nozzle member 72. The second liquid recovery portion 41 includes, for example, a vacuum system (suction apparatus) such as a vacuum pump, a gas-liquid separator that separates a gas from the recovered liquid LQ, and a tank that stores the recovered liquid LQ. Operation of the second liquid recovery portion 41 is controlled by a control apparatus CONT. It is to be noted that the second liquid recovery mechanism 40 of the exposure apparatus EX need not include all of the vacuum system, gas-liquid separator, tank, etc. but at least some of them may be substituted by equipment of the factory or the like where the exposure apparatus EX is installed.

FIG. 2 is a side cross-sectional view showing the vicinity of the first and second optical elements LS 1 and LS2. The first optical element LS 1 is a plane parallel plate without refractive power that can transmit the exposure light EL. The bottom surface T1 and the upper surface T2 thereof are parallel to each other. The projection optical system PL including the first optical element LS 1 has an imaging characteristic such as aberration within a predetermined tolerance range. The outer diameter of the upper surface T2 is larger than that of the bottom surface T1. The first optical element LS1 has a flange portion F1. The flange portion F 1 of the first optical element LS 1 is held by the holding member (lens cell) 60. The bottom surface T1 and upper surface T2 of the first optical element LS1 held by the holding member 60 are substantially parallel with the XY plane. Since the surface of the substrate W held on the substrate stage PST is substantially parallel with the XY plane, the bottom surface T1 and the upper surface T2 are substantially parallel with the surface of the substrate W held on the substrate stage PST.

The holding member 60 holding the first optical element LS1 is joined to the second nozzle member 72. The holding member 60 and the second nozzle member 72 are connected to each other by means of a plurality of bolts 61. By releasing the joint by the bolts 61, the first optical element LS1 is released from the holding by the holding member 60. That is, the first optical element LS1 is easily detachably (replaceably) mounted. Since the liquid LQ on the bottom surface T1 side of the first optical element LS1 is to be in contact with the substrate W, the first optical element LS 1 to be in contact with the liquid LQ is very likely to be contaminated. However, since the first optical element LS 1 is easily replaceable, only the contaminated first optical element LS 1 may be replaced with a new one (clean one). Therefore, exposure and measurement can be favorably performed via the projection optical system PL furnished with a clean first optical element LS 1 and via the liquid LQ.

Spacer members 62 are arranged between a bottom surface 72K of the second nozzle member 72 and an upper surface 60J of the holding member 60. The bottom surface 72K of the second nozzle member 72 faces a region, on the upper surface T2 of the first optical element LS1, that is different from the region through which the exposure light EL passes. The spacer member 62 is composed of a washer member corresponding to the bolt 61. It has a function as an adjustment mechanism to adjust the positional relationship between the second nozzle member 72 (barrel PK) and the holding member 60, and consequently the positional relationship between the second optical element LS2 held in the barrel PK and the first optical element LS1 held by the holding member 60. Here, the positional relationship between the second optical element LS2 and the first optical element LS1 includes a relative distance or relative inclination between the bottom surface T3 af the second optical element LS2 and the upper surface T2 of the first optical element LS1. The spacer members 62 are supported so as to be in contact with the upper surface 60J of the holding member 60. They are arranged at a predetermined angular space apart. The positional relationship is adjustable by appropriately modifying the thicknesses of the spacer members 62 to be used or appropriately modifying the number of the stacked spacer members 62. The second nozzle member 72 and the holding member 60 are secured by means of the bolts 61 in the condition that the spacer members 62 are arranged between the bottom surface 72K of the second nozzle member 72 and the upper surface 60J of the holding member 60.

The second optical element LS2 is an optical element with refractive power (lens power). The bottom surface T3 of the second optical element LS2 is flat, and the upper surface T4 is formed in a convex shape curved outwardly toward the object side (mask M side). Thus, it has positive refractive power. The outer diameter of the upper surface T4 is larger than that of the bottom surface T3. The second optical element LS2 has a flange surface F2. The edge portion of the flange surface F2 of the second optical element LS2 is supported by a support portion 58 provided at the lower end of the barrel PK. The second optical element LS2 (and the optical elements LS3 to LS7) are configured to be held in the barrel PK.

The bottom surface T3 of the second optical element LS2 supported by the support portion 58 is substantially parallel with the upper surface T2 of the first optical element LS 1 supported by the holding member 60. As described above, the upper surface T4 of the second optical element LS2 has positive refractive power. Therefore, reflection loss of light that enters the upper surface T4 (exposure light EL) is reduced, and consequently high numerical aperture on the image side are secured. The second optical element LS2 with refractive power (lens power) is supported by the support portion 58 of the barrel PK in a favorably positioned manner. In this embodiment, the outer diameter of the bottom surface T3 of the second optical element LS2 facing the first optical element LS 1 is formed larger than that of the upper surface T2 of the first optical element LS 1.

The exposure light EL emitted from the illumination optical system IL passes through: the optical elements LS7 to LS3; a predetermined region of the upper surface T4 of the second optical element LS2; and a predetermined region of the bottom surface T3, and then enters the liquid LQ in the first space K1. The exposure light EL having passed through the liquid LQ in the first space K1 passes through: a predetermined region of the upper surface T2 of the first optical element LS1; and a predetermined region of the bottom surface T1, then enters the liquid LQ in the image plane side space K0, and thus reaches the substrate W.

The first nozzle member 71 constitutes a part of the first immersion mechanism I . It is an annular member provided so as to surround a side surface 71T of the first optical element LS1. The first nozzle member 71 can be formed of, for example, titanium, stainless steel (e.g., SUS316), duralumin, alloy containing these (e.g., titanium alloy), silica, glass ceramics (e.g., Zerodur (registered trademark)), Si (silicon) crystal, and amorphous material. The first nozzle member 71 is arranged in the vicinity of the front end on the image plane side of the projection optical system PL. It is provided between the flange portion F1 of the first optical element LS 1 and the substrate W (the substrate stage PST) so as to surround the first optical element LS 1 of the projection optical system PL. The bottom surface T1 of the first optical element LS 1 held by the holding member 60 is substantially flush with a bottom surface 71A of the first nozzle member 71.

A predetermined space (gap) G1 is provided between an inner side surface 71T of the first nozzle member 71 and a side surface LT1 of the first optical element LS1. The projection optical system PL (first optical element LS1) is vibrationally separated from the first nozzle member 71 by the gap G1. As a result, vibration generated in the first nozzle member 71 is prevented from being directly transferred to the projection optical system PL side. The inner side surface 71 T of the first nozzle member 71 has liquid repellency (water repellency) to the liquid LQ. Therefore, flow of the liquid LQ into the gap G1 between the side surface LT1 of the first optical element LS 1 and the inner side surface 71T of the first nozzle member 71 is suppressed.

The liquid supply port 12 for supplying the liquid LQ and the liquid collection port 22 for recovering the liquid LQ are formed in the bottom surface 71A of the first nozzle member 71. In the following description, the liquid supply port 12 of the first immersion mechanism 1 is appropriately referred to as the first supply port 12, and the liquid collection port 22 of the first immersion mechanism 1 is appropriately referred to as the first collection port 22.

The first supply port 12 is provided above the substrate W supported on the substrate stage PST so as to face the surface of the substrate W. The first supply port 12 and the surface of the substrate W are spaced apart at a predetermined distance from each other. The first supply port 12 is provided so as to surround the projection region AR1 of the projection optical system PL onto which the exposure light EL is shone. In this embodiment, a plurality of the first supply ports 12 are formed in the bottom surface 71A of the first nozzle member 71 so as to surround the projection region AR1.

The first collection port 22 is provided above the substrate W supported on the substrate stage PST so as to face the surface of the substrate W. The first collection port 22 and the surface of the substrate W are spaced apart at a predetermined distance from each other. The first collection port 22 is provided outside the first supply ports 12 with respect to the projection region AR1 of the projection optical system PL. It is formed in an annular slit shape so as to surround the first supply ports 12 and the projection region AR1 onto which the exposure light EL is shone.

A porous member 22P with a plurality of pores is arranged in the first collection port 22 so as to cover the first collection port 22. The porous member 22P is composed of a mesh member with a plurality of pores. The porous member 22P can be formed by making pores in a plate member that serves as a base material for the porous member, the plate member being made of silica, titanium, stainless steel (e.g., SUS316), ceramics, lyophilic material, or the like. The porous member 22P may be subjected to a surface treatment for suppressing elution of impurities into the liquid LQ or a surface treatment for increasing the degree of lyophilicity. As for such surface treatments, a treatment for attaching chromic oxide to the porous member 22P can be listed. One example is a "GOLD EP" treatment or a "GOLD EP WHITE" treatment by Kobelco Eco-Solutions Co., Ltd. By performing such a surface treatment, an unfavorable situation such as where impurities are eluted from the porous member 22P into the liquid LQ can be prevented. Furthermore, the first and second nozzle members 71 and 72 may be subjected to the aforementioned surface treatment.

In the interior of the first nozzle member 71, there is provided a first supply passage 14 as an internal passage for connecting between each of the supply ports 12 and the supply pipe 13. The first supply passage 14 formed in the first nozzle member 71 is branched, part way along its course, so as to be connectable to each of the first supply ports 12. Furthermore, in the interior of the first nozzle member 71, there is provided a first recovery passage 24 as an internal passage for connecting between the annular first collection port 22 and the recovery pipe 23. The first recovery passage 24 is formed in an annular shape so as to correspond to the annular first collection port 22. It includes an annular passage connected to the collection port 22 and a manifold passage for connecting between a part of the annular passage and the recovery pipe 23.

When forming the immersion region LR1 of the liquid LQ, the control apparatus CONT uses the first liquid supply mechanism 10 of the first immersion mechanism 1 and the first liquid recovery mechanism 20 to supply and recover the liquid LQ onto/from the substrate W. When supplying the liquid LQ onto the substrate W, the control apparatus CONT sends out the liquid LQ from the first liquid supply portion 11 to supply the liquid LQ onto the substrate W from the first supply port 12 provided above the substrate W, via the first supply pipe 13 and the first supply passage 14 of the first nozzle member 71. When recovering the liquid LQ on the substrate W, the control apparatus CONT drives the first liquid recovery portion 21. By means of drive from the first liquid recovery portion 21, the liquid LQ on the substrate W flows into the first recovery passage 24 of the first nozzle member 71 via the first collection port 22 provided above the substrate W and is recovered into the first liquid recovery portion 21 via the first recovery pipe 23. The liquid LQ fills the image plane side space K0 between the substrate W and the bottom surface 71A of the first nozzle member 71 as well as the bottom surface T1 of the optical element LS1 of the projection optical system PL to form the first immersion region LR1.

The second nozzle member 72 constitutes a part of the second immersion mechanism 2. It is an annular member provided between the flange surface F2 of the second optical element LS2 and the first optical element LS 1 so as to surround a side surface 72T of the second optical element LS2. The flange surface F2 of the second optical element LS2 faces the upper surface 72J of the second nozzle member 72. The second nozzle member 72 can also be formed of the material similar to the aforementioned material for the first nozzle member. The second nozzle member 72 is connected to the lower end portion of the barrel PK, and is supported by the barrel PK. As described above, the second nozzle member 72 is substantially integral with the barrel PK. Therefore, the second nozzle member 72 constitutes a part of the barrel PK. A predetermined space (gap) G2 is provided between an inner side surface 72T of the second nozzle member 72 and a side surface LT2 of the second optical element LS2.

The liquid supply port 32 for supplying the liquid LQ and the liquid collection port 42 for recovering the liquid LQ are formed in the second nozzle member 72. In the following description, the liquid supply port 32 provided in the second nozzle member 72 of the second immersion mechanism 2 is appropriately referred to as the second supply port 32, and the liquid collection port 42 of the second immersion mechanism 2 is appropriately referred to as the second collection port 42.

The second supply port 32 is provided at a position, in the inner side surface 72T of the second nozzle member 72, that faces the first space K1. The second collection port 42 is provided in inner side surface 72T of the second nozzle member 72, that faces the side surface LT2 of the second optical element LS2. The second collection port 42 is provided at a position higher than the bottom surface T3 of the second optical element LS2. In this embodiment, the second collection port 42 faces in the horizontal direction. However, it may face in, for example, the obliquely downward or upward direction.

In the interior of the second nozzle member 72, there is provided a second supply passage 34 as an internal passage for connecting between the second supply port 32 and the supply pipe 33. Furthermore, in the interior of the second nozzle member 72, there is provided a second recovery passage 44 as an internal passage for connecting between the second collection port 42 and the recovery pipe 43.

A bent portion 44R bending upward to a position higher than the second collection port 42 is provided in a part of the second recovery passage 44 formed in the second nozzle member 72. The connection portion between the second recovery passage 44 and the second recovery pipe 43 is provided at a position lower than the bent portion 44R. That is, the liquid LQ collected from the second collection port 42 flows substantially in the horizontal direction, then flows upward, then flows downward, and subsequently flows into the second recovery pipe 43. In an upper portion of the bent portion 44R, there is provided a hole 44K that extends between the inside and the outside of the second recovery passage 44. Through the hole 44K, the second recovery passage 44 is open to the atmosphere. With the provision of the hole 44K for opening to the atmosphere, the first space K1 (the space inside the barrel PK) can be prevented from becoming negatively pressurized even when the first space K1 is sucked by the second liquid recovery portion 41. That is, when pressure in the first space K1 and the second recovery passage 44 connecting to the first space K1 is reduced by the sucking operation of the second liquid recovery portion 41, a gas flows into the second recovery passage 44 via the hole 44K. Therefore, the first space K 1 and the second recovery passage 44 connecting to the first space K1 can be prevented from becoming negatively pressurized. Thus, with the overflow structure in which the bent portion 44R with the hole 44K is provided at a position higher than the connection portion between the second collection port 42 as well as the second recovery passage 44 and the second recovery pipe 43, the space K1 can be prevented from becoming negatively pressurized.

In this embodiment, the second supply port 32 is provided on the +X side of the first space K1, while the second collection port 42 is provided on the -X side of the first space K1. The second supply port 32 is of a slit shape with a predetermined width. The second collection port 42 is formed larger than the second supply port 32. By forming the second collection port 42 larger than the second supply port 32, liquid recovery can be smoothly performed. Note that a porous member may be arranged in the second collection port 42 as in the case of the first collection port 22.

The number and arrangement of the second supply ports 32 and the second collection ports 42, the number and arrangement of the second supply passages 34 and the second recovery passages 44, and the like can be set freely. For example, the second supply ports 32 may be formed at a plurality of predetermined positions in the second nozzle member 72. Similarly, the second collection ports 42 may be formed at a plurality of predetermined positions in the second nozzle member 72.

When forming the second immersion region LR2 of the liquid LQ, the control apparatus CONT uses the second liquid supply mechanism 30 of the second immersion mechanism 2 and the second liquid recovery mechanism 40 to supply and recover the liquid LQ onto/from the first space K1. When supplying the liquid LQ to the first space K1, the control apparatus CONT sends out the liquid LQ from the second liquid supply portion 31 to supply the liquid LQ to the first space K1 from the second supply port 32 via the second supply pipe 33 and the second supply passage 34 of the second nozzle member 72. When recovering the liquid LQ in the first space K1, the control apparatus CONT drives the second liquid recovery portion 41. By means of drive from the second liquid recovery portion 41, the liquid LQ in the first space K1 flows into the second recovery passage 44 of the second nozzle member 72 via the second collection port 42 provided at a position higher than the bottom surface T3 of the second optical element LS2 and is recovered into the second liquid recovery portion 41 via the second recovery pipe 43. The liquid LQ fills the first space K1 between the bottom surface T3 of the second optical element LS2 and the upper surface T2 of the first optical element LS 1 to form the second immersion region LR2.

A sealing member 64 is provided between the upper surface T2 of the first optical element LS1 and the bottom surface 72K of the second nozzle member 72. Furthermore, a sealing member 63 is provided between the upper surface 60J of the holding member 60 and the bottom surface 72K of the second nozzle member 72. The sealing members 63 and 64 are for suppressing the circulation of the liquid LQ between the first space K1 and the space thereoutside. The sealing members 63 and 64 especially suppress the liquid LQ filled in the first space K1 from flowing out into the space thereoutside. The sealing members 63 and 64 mainly suppress outflow of the liquid LQ filled in the first space K1 into a third space K3 outside the barrel PK. The sealing member 64 can be provided between the upper surface 60J of the holding member 60 and the bottom surface 72K of the second nozzle member 72.

Anything can be used as the sealing member 63 or 64 as long as it can suppress circulation of the liquid LQ. An O ring, a V ring, a C ring, a ring-shaped sealing member with water-repellency, etc. can be used. In this embodiment, the sealing member 64 is a V ring, while the sealing member 63 is an O ring. Note that the sealing member 64 may be dispensed with.

Furthermore, a sealing member 76A is provided in the gap G2 between the inner side surface 72T of the second nozzle member 72 and the side surface LT2 of the second optical element LS2. Sealing members 76B and 76C are provided between the upper surface 72J of the second nozzle member 72 and the flange surface F2 of the second optical element LS2 facing the upper surface 72J. The sealing member 76B and the sealing member 76C are arranged in concentric circles with the optical axis of the second optical element LS2 at their center. The sealing members 76 (76A, 76B, 76C) are for suppressing the circulation of the liquid LQ between the first space K1 and the space thereoutside, and they also suppress outflow of the liquid LQ filled in the first space K1 into the space thereoutside. The sealing members 76 mainly suppress outflow of the liquid LQ filled in the first space K1 into the second space (the space inside the barrel PK) K2 on the upper surface T4 side of the second optical element LS2, and also suppresses the outflow of the liquid LQ into the third space K3 outside the barrel PK. In the case where there is no possibility that a second liquid LQ filled in the second space K2 flows out into the third space K3, the sealing members 76 can be omitted.

It is preferable that a plurality of sealing members 76A be provided between the inner side surface 72T of the second nozzle member 72 and the side surface LT2 of the second optical element LS2. Furthermore, it is preferable that a plurality of sealing members 76B be provided between the upper surface 72J of the second nozzle member 72 and the flange surface F2 of the second optical element LS2 facing the upper surface 72J. As a result, outflow of the liquid LQ filled in the first space K1 can be more securely suppressed. When a plurality of the sealing members 76A are provided, the sealing member 76B can be omitted. Alternatively, when a plurality of the sealing members 76B are provided, the sealing member 76A can be omitted.

In a recess portion 75 formed in the second nozzle member 72, there is provided a detector 74 for detecting whether or not the liquid LQ has flowed out of the first space K1. The detector 74 is constituted by an optical fiber. As shown in FIG. 2, it is arranged in the recess portion 75 formed in the second nozzle member 72. The optical fiber 74 is an optical fiber having a core portion through which light propagates, without a cladding portion around the core portion (a claddingless fiber). The core portion of the optical fiber 74 has a refractive index that is higher than that of a gas therearound (air, in this embodiment) and is lower than that of the liquid LQ (pure water, in this embodiment). As a result, when the surrounding area of the optical fiber 74 is filled with air, light propagates while being enclosed in the core portion with a refractive index higher than that of air. That is, light having entered the incident end portion of the optical fiber 74 exits from the exit end portion without enormously reducing the amount of the light. However, when the liquid (pure water) LQ is attached to the surface of the optical fiber 74, total reflection does not occur at the interface between the liquid LQ and the optical fiber 74. As a result, light leaks to the outside from the optical fiber 74 at portion(s) the liquid is attached to. Therefore, light having entered the incident end portion of the optical fiber 74 is reduced in intensity when exiting from the exit end portion. To address this, the optical fiber 74 is arranged at a predetermined position of the exposure apparatus EX and intensity at the exit end portion of the optical fiber 74 is measured. Thus, the control apparatus CONT can detect whether or not the liquid LQ has been attached to the optical fiber 74, that is, the liquid LQ has flowed out. Since air has a refractive index of about 1 and water has a refractive index of about 1.4 to 1.6, it is preferable that the core be made of material with a refractive index of, for example, about 1.2.

Here, the detector 74 is arranged inside the recess portion 75. However, as shown in FIG. 3, the detector 74 may be arranged, for example, in a space (measurement space), different from the recess portion 7S, that connects via a passage 304 to a hole portion (sampling port) 300 provided in a portion of the recess portion 75, and the liquid LQ flowing into the measurement space 301 via the sampling port 300 and the passage 304 may be detected by the detector 74 arranged in the measurement space 301. Here, the measurement space 301 is a space formed by the second nozzle member 72 and a recess portion 303 of a first member 302 joined to the second nozzle member 72. The passage 304 for connecting the sampling port 300 of the recess portion 75 with the measurement space 301 is formed inside the second nozzle member 72 separately from the second supply passage 34 and the second recovery passage 44.

A through-hole 65 for draining the liquid LQ in the first space K1 is provided at a predetermined position in the holding member 60 for holding the first optical element LS1. A lid 66 for covering the through-hole 65 is arranged in the through-hole 65. The through-hole 65 penetrates between the upper surface 60J and a bottom surface 60K of the holding member 60. Here, the upper surface 60J of the holding member 60 is provided at a position lower than the upper surface T2 of the first optical element LS 1 held thereon. Therefore, the upper end of the through-hole 65 is provided at a position lower than the upper surface T2 of the first optical element LS1. At the time of maintenance, etc., the removal of the lid 66 allows smooth drainage of the liquid LQ in the first space K1 into the outside.

The exposure apparatus EX includes a first detector 101 that can detect a pressure P₁ of the liquid LQ in the first space K1. The exposure apparatus EX further includes a second detector 102 that can detect a pressure P₂ of the gas G in the second space K2. The exposure apparatus EX further includes a detector 100 that can detect a pressure P₀ of the liquid LQ in the image plane side space K0. In this embodiment, the first detector 101 1 is provided, in the second nozzle member 72, at a position that allows contact with the liquid LQ. To be more specific, as shown in FIG. 2, it is provided in the vicinity of the second collection port 42. The second detector 102 is provided at a predetermined position on the inner wall surface of the barrel PK. The detector 100 is provided, on the bottom surface 71A of the first nozzle member 71, at a predetermined position to be in contact with the liquid LQ in the image plane side space K0. Note that each of the detectors 100 to 102 can be provided at any position as long as it is capable of detecting the pressure. For example, the first detector 101 may be provided, on the bottom surface T3 of the second optical element LS2, at a predetermined position that does not interfere with the optical path of the exposure light EL.

Here, the first detector 101 is provided at a position that allows contact with the liquid LQ in the first space K1, in order to detect the pressure P₁ of the liquid LQ in the first space K1. However, as shown in FIG. 4, a light detector 400 that can optically detect the position of the surface of the liquid LQ by shining detection light onto the surface of the liquid LQ (the surface of water) filled in the second recovery passage 44 may be provided, for example, over the hole 44K of the bent portion 44R of the second nozzle member 72, and the pressure P₁ of the liquid LQ in the first space K1 may be acquired based on the position of the surface of the liquid LQ. In this case, if the relationship between the pressure P₁ of the liquid LQ in the first space K1 and the position of the surface of the liquid LQ at the measurement position (the bent portion 44R) is previously acquired, the pressure P₁ of the liquid LQ in the first space K1 can be obtained based on the acquired relationship and the detection results from the light detector 400.

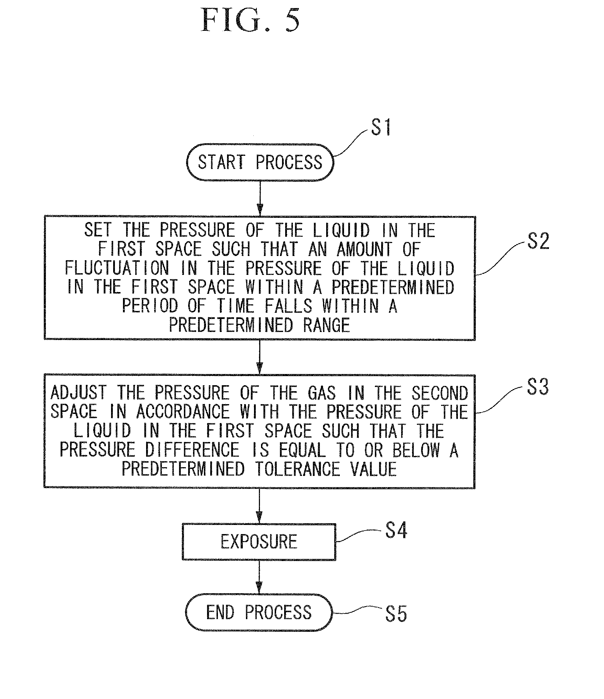

Next, a method for exposing a pattern image of the mask M onto the substrate W by use of the exposure apparatus EX with the aforementioned configuration will be described with reference to the flowchart of FIG. 5.

When the start of process is instructed (step S1), the control apparatus CONT sets the target pressure Pᵣ of the liquid LQ in the first space K1 such that an amount of fluctuation in the pressure P₁ of the liquid LQ in the first space K1 within a predetermined period of time Th falls within a predetermined range Ph (step S2).

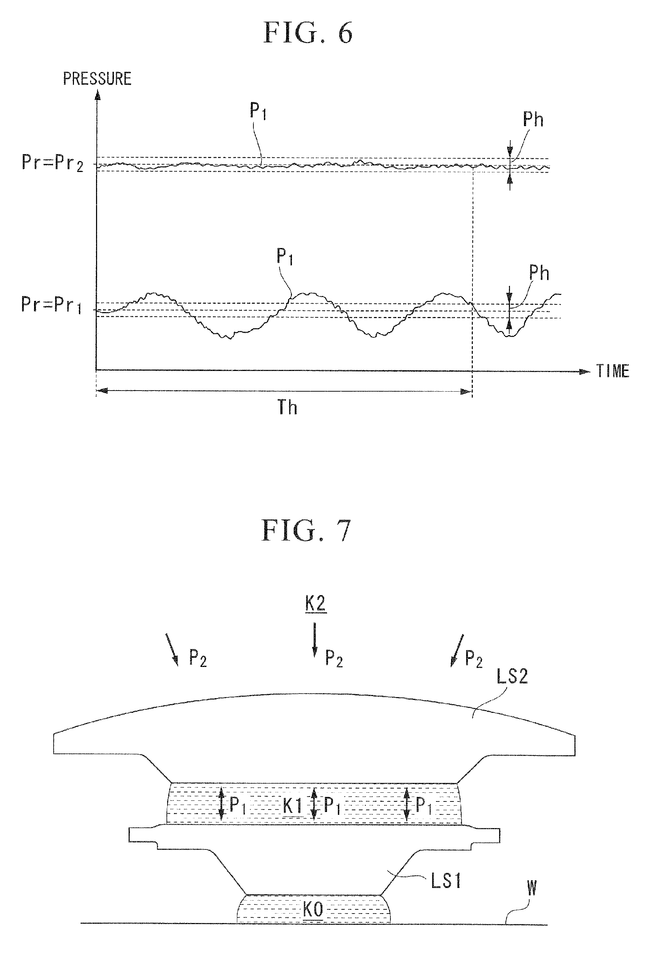

FIG. 6 shows a relationship between the target pressure Pᵣ of the liquid LQ in the first space K1 and the amount of fluctuation in the pressure P₁ of the liquid LQ in the first space K1. When the liquid LQ is supplied from the second liquid supply mechanism 30 of the second immersion mechanism 2 to the first space K1, the pressure P₁ of the liquid LQ in the first space K1 may fluctuate with respect to the target pressure Pᵣ due to pulsation of the second liquid supply portion 31, shape of the supply pipe 33 (elbow portion, etc.), etc. As shown in FIG. 6, the amount of fluctuation in the pressure P₁ of the liquid LQ in the first space K1 when the target pressure Pᵣ is made Pᵣ₂ (for example, about 300 Pa) is smaller than the amount of fluctuation in the pressure P₁ of the liquid LQ in the first space K1 when the target pressure Pᵣ is made Pᵣ₁, Pᵣ₁ being smaller than Pᵣ₂ (for example, about 100 Pa). That is, setting the target pressure Pᵣ to a higher value can suppress the amount of fluctuation in the pressure P₁ of the liquid LQ in the first space K1 to a smaller value. In other words, setting the target pressure Pᵣ of the liquid LQ filled in the first space K1 by the second immersion mechanism 2 to a higher value can improve controllability of the pressure P₁ of the liquid LQ in the first space K1. In the example shown in FIG 6, when the target pressure Pᵣ = Pᵣ₁, a favorable controllability in controlling the pressure P₁ cannot be obtained. Therefore, the amount of fluctuation in the pressure P₁ of the liquid LQ in the first space K1 is not allowed to fall within the predetermined range (a tolerance range) Ph. However, when the target pressure Pᵣ is equal to Pᵣ₂, the amount of fluctuation in the pressure P₁ of the liquid LQ in the first space K1 is allowed to fall within the predetermined range (a tolerance range) Ph.

Thus, before exposing the substrate W, the control apparatus CONT supplies the liquid LQ to the first space K1 from the second liquid supply mechanism 30 while changing the target pressure Pᵣ, and uses the first detector 101 to detect the pressure (pressure fluctuation) of the liquid LQ in the first space K1 at that time. The control apparatus CONT then determines the target pressure Pᵣ of the liquid LQ in the first space K1 based on the detection results from the first detector 101 such that the amount of fluctuation in the pressure P₁ of the liquid LQ in the first space K1 within a predetermined period of time Th falls within the predetermined tolerance range Ph. In this embodiment, the target pressure Pᵣ of the liquid LQ in the first space K1 is determined such that as the tolerance range Ph, the amount of fluctuation in the pressure P1 in the first space K1 within a predetermined period of time (for example, two minutes) Th is within ±20 to 30 Pa with respect to the target pressure Pᵣ. In this embodiment, the target pressure Pᵣ of the liquid LQ in the first space K1 is set to be about 300 Pa.

After setting the pressure (the target pressure) of the liquid LQ in the first space K1, the control apparatus CONT adjusts the pressure P₂ of the gas G in the second space K2 in accordance with the pressure P₁ of the liquid LQ in the first space K1 such that a pressure difference ΔP (= P₁-P₂) between the pressure P₁ of the liquid LQ in the first space K 1 and the pressure P₂ of the gas G in the second space K2 is a predetermined tolerance value or less (step S3).

As schematically shown in FIG. 7, there is a possibility that the second optical element LS2 will be deformed or moved in accordance with the pressure difference ΔP between the pressure P₁ of the liquid LQ in the first space K1 and the pressure P₂ of the gas G in the second space K2 and that the deformation or movement will change the imaging characteristic of the projection optical system PL. To be more specific, when the pressure difference △P becomes larger, there is a possibility that the second optical element LS2 will be deformed or moved in accordance with the pressure difference ΔP, resulting in degradation in pattern transfer accuracy when the pattern is transferred onto the substrate W via the projection optical system PL. That is, when the pressure difference △P exceeds the tolerance value, there is a possibility that the second optical element LS2 will be deformed or moved to a degree that a desired pattern transfer accuracy cannot be obtained. To address this, the control apparatus CONT adjusts the pressure P₂ of the gas G in the second space K2 such that a desired imaging characteristic (pattern transfer accuracy) is obtained, and thus sets the pressure difference ΔP equal to or below the tolerance value.

Here, the tolerance value of the pressure difference ΔP is a value previously determined by experiment or simulation to obtain the desired imaging characteristic (pattern transfer accuracy). By setting the pressure difference ΔP equal to or below the tolerance value, the amount of deformation or movement of the second optical element LS2 can be suppressed and a desired pattern transfer accuracy can be obtained.

In the memory apparatus MRY, there is previously stored a relationship between the pressure difference ΔP and the imaging characteristic of the projection optical system PL. The relationship between the pressure difference ΔP and the imaging characteristic of the projection optical system PL has already been obtained by experiment or simulation. The control apparatus CONT refers to memory information in the memory apparatus MRY to adjust the pressure P₂ of the gas G in the second space K2 in accordance with the pressure P₁ of the liquid LQ in the first space K1 such that the desired imaging characteristic (pattern transfer accuracy) is obtained. As described above, the imaging characteristic of the projection optical system PL changes as a result of deformation or movement of the second optical element LS2 due to the pressure difference ΔP. Therefore, the memory information stored in the memory apparatus MRY includes information on the amount of deformation or movement of the second optical element LS2 in accordance with the pressure difference ΔP.

When adjusting the pressure P₂ of the gas G in the second space K2, the control apparatus CONT uses the first and second detectors 101 and 102 to detect the pressure P₁ of the liquid LQ in the first space K1 and the pressure P₂ of the gas G in the second space K2. The control apparatus CONT uses the gas substitution apparatus 3 to adjust the pressure P₂ of the gas G in the second space K2 based on the detection results from the first and second detectors 101 and 102 such that the pressure difference ΔP is equal to or below the tolerance value.

Here, one example of a procedure for acquiring the above relationship (tolerance value) will be described. First, the control apparatus CONT uses the second immersion mechanism 2 to fill the first space K1 with the liquid LQ and at the same time uses the first immersion mechanism 1 to fill the image plane side space K0 with the liquid LQ. The control apparatus CONT then uses the second immersion mechanism 2 to set the pressure P₁ of the liquid LQ in the first space K1 to a predetermined value and at the same time exposes a test pattern onto a test substrate via the projection optical system PL and the liquid LQ while changing the pressure P₂ of the gas G in the second space K2 by use of the gas substitution apparatus 3. The pressure P₁ of the liquid LQ in the first space K1 and the pressure P₂ of the gas G in the second space K2 during the test exposure are detected (monitored) by the first and second detectors 101 and 102, respectively. The detection results from the first and second detectors 101 1 and 102 are outputted to the control apparatus CONT. Therefore, the control apparatus CONT can acquire the pressure difference ΔP during the test exposure between the pressure P₁ of the liquid LQ in the first space K1 and the pressure P₂ of the gas G in the second space K2, based on the detection results from the first detector 101 1 and the second detector 102. Next, the test pattern formed on the test substrate is measured by a pattern formation measuring apparatus such as an SEM. The measurement results from the pattern formation measuring apparatus are transmitted to the control apparatus CONT. The control apparatus CONT can acquire the imaging characteristic of the projection optical system PL based on the measurement results from the pattern formation measuring apparatus. The control apparatus CONT can derive the relationship between the pressure difference ΔP, between the pressure P₁ of the liquid LQ in the first space K1 and the pressure P₂ of the gas G in the second space K2, and the pattern formation (pattern transfer accuracy) on the test substrate obtained by the test exposure under the condition of the pressure difference ΔP. As a result, the control apparatus CONT can acquire the relationship between the pressure difference ΔP and the imaging characteristic (pattern transfer accuracy) of the projection optical system PL. The control apparatus CONT then acquires the pressure difference ΔP, between the pressure P₁ of the liquid LQ in the first space K1 and the pressure P₂ of the gas G in the second space K2, that allows the imaging characteristic (pattern transfer accuracy) of the projection optical system PL to be in a desired state. The control apparatus CONT stores the relationship between the pressure difference ΔP and the imaging characteristic of the projection optical system PL as a map data in the memory apparatus MRY.

The relationship between the pressure difference ΔP and the imaging characteristic (pattern transfer accuracy) of the projection optical system PL may be acquired by a simulation. For example, as information to be stored in the memory apparatus MRY, the amount of deformation or movement of the second optical element LS2 in accordance with the pressure difference ΔP can be acquired by a simulation. The amount of deformation of the second optical element LS2 in accordance with the pressure difference ΔP varies in accordance with material or physicality (including hardness or Young's modulus), or shape of the second optical element LS2. Furthermore, the amount of movement of the second optical element LS2 varies in accordance with the holding mechanism of the second optical element LS2 (the holding mechanism of the barrel PK). The control apparatus CONT can acquire the amount of deformation or movement of the second optical element LS2 in accordance with the pressure difference ΔP by experiment or simulation, and can store the information on the amount in the memory apparatus MRY. When exposing the substrate W for manufacturing devices, the control apparatus CONT makes the pressure difference ΔP between the pressure P₁ of the liquid LQ in the first space K1 and the pressure P₁ of the gas G in the second space K2 equal to or below the tolerance based on the above-mentioned memory information such that the amount of deformation or movement of the second optical element LS2 falls within the tolerance range, so as to obtain the desired imaging characteristic.

After optimizing the pressure difference ΔP between the pressure P₁ of the liquid LQ in the first space K1 and the pressure P₂ of the gas G in the second space K2, the control apparatus CONT makes preparations for performing the liquid immersion exposure process onto the substrate W for manufacturing devices. That is, after the substrate W for manufacturing devices is loaded to the substrate stage PST in the loading position, the control apparatus CONT moves the substrate stage PST holding the substrate W below the projection optical system PL, i.e., to the exposure position. The control apparatus CONT then uses the first immersion mechanism 1 and the second immersion mechanism 2 to fill the image plane side space K0 and the first space K1, respectively, with the liquid LQ in a state that the substrate stage PST and the first optical element LS1 of the projection optical system PL face each other. In this state, the pressure difference ΔP between the pressure P₁ of the liquid LQ in the first space K1 and the pressure P₂ of the gas G in the second space K2 is optimized.

After optimizing the pressure difference ΔP between the pressure P₁ of the liquid LQ in the first space K1 and the pressure P₂ of the gas G in the second space K2, the control apparatus CONT performs a measurement process relating to the exposure process. Here, at a predetermined position on the substrate stage PST, there is provided a substrate alignment system as disclosed in, for example, Japanese Unexamined Patent Publication, First Publication No. H04-65603 and a reference member (measuring member) furnished with a reference mark measured by a mask alignment system as disclosed in Japanese Unexamined Patent Publication, First Publication No. H07-176468. Furthermore, at predetermined positions on the substrate stage PST, there are provided, as optical measurement portions, an illuminance non-uniformity sensor as disclosed in, for example, Japanese Unexamined Patent Application, First Publication No. S57-117238, a space image measurement sensor as disclosed in, for example, Japanese Unexamined Patent Application, First Publication No. 2002-14005, an irradiated light amount sensor (illuminance sensor) as disclosed in, for example, Japanese Unexamined Patent Application, First Publication No. H11-16816, etc. Before performing the exposure process onto the substrate W, the control apparatus CONT performs measurement of the mark on the reference member and other various measurement operations using the optical measurement portion. Based on the measurement results, the control apparatus CONT then performs an alignment process of the substrate W and an imaging characteristic adjustment (calibration) process of the projection optical system PL.

Here, in this embodiment, the pressure P₂ of the gas G in the second space K2 is adjusted in accordance to the pressure P₁ of the liquid LQ in the first space K1. Therefore, in accordance with the pressure P₂ of the gas G in the second space K2, the control apparatus CONT uses the imaging characteristic adjustment apparatus LC to drive a specific optical element of the optical elements LS1 to LS7 that constitute the projection optical system PL such that a desired imaging characteristic is obtained and thus to adjust the imaging characteristic. As a result, even when the pressure P₂ of the gas G in the second space K2 is adjusted in accordance to the pressure P₁ of the liquid LQ in the first space K1, an imaging characteristic including the position of the image plane via the projection optical system PL and the liquid LQ can be in a desired state. When adjustment of the imaging characteristic is made, the pressure P₀ of the liquid LQ in the image plane side space K0 may be taken into consideration.

After the above-mentioned calibration process and the like, while moving the substrate stage PST holding the substrate W in the X axis direction (the scanning direction), the control apparatus CONT irradiates the substrate W with the exposure light EL via the projection optical system PL, the liquid LQ between the second optical element LS2 and the first optical element LS1, and the liquid LQ between the first optical element LS1 and the substrate W to projection-expose the pattern image of the mask M onto the substrate W (step S4).

In this embodiment, the first optical element LS1 made of a plane parallel plate is arranged below the second optical element LS2 with lens power. By filling with liquid LQ the image plane side space K0 on the bottom surface T1 side of the first optical element LS1 and the first space K1 on the upper surface T2 side of the first optical element LS1, reflection loss at the bottom surface T3 of the second optical element LS2 and the upper surface T2 of the first optical element LS1 is reduced. Thus, the substrate W can be favorably exposed in a state with high numerical aperture on the image plane side being secured.

By not performing supply operation and recovery operation of the liquid LQ by the second immersion mechanism 2 during irradiation of the substrate W with the exposure light EL, that is, by performing exposure in a state with the first space K1 being filled with the liquid LQ, the pressure P₁ of the liquid LQ in the first space K1 can be favorably maintained during the exposure of the substrate W. Furthermore, by not performing supply operation and recovery operation of the liquid LQ during exposure of the substrate W, vibration involved in supply and recovery of the liquid LQ does not occur during exposure of the substrate W. Therefore, degradation in exposure accuracy due to vibration can be prevented.

However, supply operation and recovery operation of the liquid LQ by the second immersion mechanism 2 can be performed also during exposure of the substrate W. In this case, a liquid recovery apparatus (not shown in the figure) may be connected to the through-hole 65 with the lid 66 removed, and the liquid LQ may be recovered via the through-hole 65. Also during exposure, the pressure P₁ of the liquid LQ in the first space K1 is monitored by the first detector 101, while the pressure P₂ of the gas G in the second space K2 is monitored by the second detector 102. The control apparatus CONT, also during exposure of the substrate W, can adjust the pressure P₂ of the gas G in the second space K2 based on the detection results from the first detector 101 by use of the gas substitution apparatus 3 such that the pressure difference ΔP between the pressure P₁ of the liquid LQ in the first space K1 and the pressure P₂ of the gas G in the second space K2 is equal to or below a predetermined tolerance value. Thus, also during exposure, the control apparatus CONT can adjust the pressure P₂ of the gas G in the second space K2 based on the detection results from the first and second detectors 101 and 102. Furthermore, as described with reference to FIG. 6, the pressure P₁ of the liquid LQ in the first space K1 is set to a high value of about 300 Pa and the amount of fluctuation therein is suppressed. Since the amount of fluctuation in the pressure P₁ of the liquid LQ in the first space K1 is small, a large amount in the pressure difference ΔP between the pressure P₁ of the liquid LQ in the first space K1 and the pressure P₂ of the gas G in the second space K2 can be suppressed and the pressure difference ΔP can be suppressed equal to or below the tolerance value without adjusting the pressure P₂ of the gas G in the second space K2 in accordance with the pressure P₁ of the liquid LQ in the first space K1 during exposure of the substrate W.

In completion of the exposure of the substrate W (step S5), the control apparatus CONT stops the supply of the liquid LQ by the first liquid supply mechanism 10, and uses the first liquid recovery mechanism 20, etc. to recover the liquid LQ in the first immersion region LR1 (the liquid in the image plane side space K0). Furthermore, the control apparatus CONT uses the first collection port 22 of the first liquid recovery mechanism 20, etc. to recover the liquid LQ remaining on the substrate W and the substrate stage PST. After completion of the exposure of the substrate W, the control apparatus CONT recovers the liquid LQ in the second immersion region LR2 formed in the first space K1 via the second collection port 42 of the second liquid recovery mechanism 40, and at the same time supplies a new liquid LQ to the first space K1 from the first supply port 32 of the second liquid supply mechanism 30. As a result, the liquid LQ filled in the first space K1 is replaced.

As described above, an adjustment of the pressure difference ΔP between the pressure P₁ of the liquid LQ in the first space K1 and the pressure P₂ of the gas G in the second space K2 can suppress the occurrence of an unfavorable situation where the second optical element LS2 is deformed or moved. Therefore, degradation in imaging characteristic (pattern transfer accuracy) of the projection optical system PL involved in the deformation or movement of the second optical element LS2 can be suppressed, and thus exposure accuracy and measurement accuracy can be favorably maintained.

In this embodiment, it is configured such that by setting the pressure P₁ of the liquid LQ in the first space K1 to a high value, the amount of fluctuation in the pressure P1 is made small. Thus, without performing an adjustment of the pressure P₂ of the gas G in the second space K2 in accordance with the pressure P₁ of the liquid LQ in the first space K1 during exposure of the substrate W (or by performing a slight adjustment thereof), the pressure difference ΔP can be suppressed so as to be equal to or below the tolerance value. Furthermore, in the case where the liquid LQ supplied from equipment of for example a factory is used, setting the pressure P₁ of the liquid LQ in the first space K1 to a high value allows the use of the liquid LQ supplied from the equipment even if the pressure of the supplied liquid LQ is high, without providing a decompression apparatus, etc. for reducing the pressure of the supplied liquid LQ. On the other hand, even if the amount of fluctuation in the pressure P₁ of the liquid LQ in the first space K1 is not within the tolerance range Ph (for example, the target pressure Pᵣ = Pᵣ₁ in FIG. 6), the amount of fluctuation in the pressure P₁ of the liquid LQ in the first space K1 is not necessarily required to be suppressed within the tolerance range Ph as long as the pressure P₂ of the gas G in the second space K2 can be adjusted (can follow) such that the pressure difference ΔP is suppressed equal to or below the tolerance value in accordance with the fluctuation in the pressure P₁ of the liquid LQ in the first space K1.

In the above embodiment, when the pressure P₁ of the liquid LQ in the first space K1 is set to a high value, it is preferable that the pressure P₀ of the liquid LQ in the image plane side space K0 also be adjusted to reduce influence on the first optical element LS1 under the first space K1. That is, it is preferable that the pressure difference between the pressure P₀ of the liquid LQ in the image plane side space K0 and the pressure P₁ of the liquid LQ in the first space K1 be equal to or below a predetermined tolerance value.
Here, since the liquid LQ in the image plane side space K0 contacts with the substrate W, there is a possibility that making the value of the pressure P₀ of the liquid LQ in the image plane side space K0 too high will influence the substrate W. Therefore, it is preferable that the pressure of the liquid LQ in the first space K1 (the target pressure) be determined by taking into consideration the influence on peripheral members including the first optical element LS1 and the substrate W.

In the above embodiment, since the second optical element LS2 has lens power, adjusting the pressure difference ΔP between the pressure P₁ of the liquid LQ in the first space K1 and the pressure P₂ of the gas G in the second space K2 to suppress the deformation or movement of the second optical element LS2 is effective from the viewpoint of maintaining the imaging characteristic of the projection optical system PL. Since the first optical element LS1 is a plane parallel plate, an adjustment of the pressure difference between the pressure P₀ of the liquid LQ in the image plane side space K0 and the pressure P₁ of the liquid LQ in the first space K1 can be rougher than that of the pressure difference ΔP between the pressure P₁ of the liquid LQ in the first space K1 and the pressure P₂ of the gas G in the second space K2.

In the above embodiment, it is configured such that the gas substitution apparatus (gas supply mechanism) 3 is used to adjust the pressure difference ΔP. That is, the gas substitution apparatus 3 additionally has a function as the adjustment mechanism for adjusting the pressure difference ΔP. As a result, the configuration of the apparatus can be simplified. On the other hand, a second gas supply mechanism different from the gas substitution apparatus 3 may be connected to the barrel PK (the second space K2), and the second gas supply mechanism may be used to adjust the pressure difference ΔP.

In the above embodiment, the pressure P₂ of the gas G in the second space K2 is adjusted in accordance with (so as to follow) the pressure P₁ of the liquid LQ in the first space K1. However, the pressure P₁ of the liquid LQ in the first space K1 may be adjusted in accordance with (so as to follow) the pressure P₂ of the gas G in the second space K2.

In the above embodiment, instead of adjusting the pressure P₂ of the gas G in the second space K2, the second optical element LS2 may be deformed or moved in accordance with the pressure difference ΔP. Furthermore, the adjustment of the pressure P₂ of the gas G in the second space K2 and the deformation or movement of the second optical element LS2 can be concurrently used. Alternatively, the adjustment of the pressure P₂ of the gas G in the second space K2 and the deformation or movement of the first optical element LS 1 can be concurrently used. Furthermore, both of the first optical element LS 1 and the second optical element LS2 may be deformed or moved.

As describe above, pure water is used as the liquid LQ of this embodiment. Pure water has advantages in that it can be easily obtained in large quantities at semiconductor manufacturing plants, etc. and in that it has no adverse effects on the photoresist on the substrate W or on the optical elements (lenses), etc. In addition, pure water has no adverse effects on the environment and contains very few impurities, so one can also expect an action whereby the surface of the substrate W and the surface of the optical element provided on the front end surface of the projection optical system PL are cleaned. In the case where pure water supplied from plants, etc. has a low degree of purity, the exposure apparatus may have an extra pure water production apparatus.

In addition, the index of refraction n of pure water (water) with respect to exposure light EL with a wavelength of 193 nm is said to be nearly 1.44, so in the case where ArF excimer laser light (wavelength: 193 nm) is used as the light source of the exposure light EL, it is possible to shorten the wavelength to 1/n, that is, approximately 134 nm on the substrate W, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

When the immersion method is used as described above, the numerical aperture NA of the projection optical system may become 0.9 to 1.3. When the numerical aperture NA of the projection optical system becomes large like this, random-polarized light conventionally used as the exposure light may, because of its polarization effect, adversely affect the imaging performance; thus, a polarized light illumination method is preferably used. In this case, it is preferable that by performing linearly polarized light illumination in which the longitudinal direction of the line pattern of the line-and-space pattern on the mask (reticle) is aligned with the polarization direction, a lot of diffraction lights from S polarization components (TE polarization components), i.e., the diffraction lights from the polarization components having the polarization direction in line with the longitudinal direction of the line pattern are emitted from the pattern of the mask (reticle). When the space between the projection optical system PL and the resist applied to the surface of the substrate W is filled with the liquid, the light transmittance at the resist surface of the diffraction lights from S polarization components (TE polarization components), which contribute to the improvement of the contrast, is higher compared with the case where the space between the projection optical system PL and the resist applied to the surface of the substrate W is filled with the gas (air), a high imaging performance can be obtained even in the case where the numerical aperture NA of the projection optical system is over 1.0. Furthermore, a phase shift mask, an oblique entrance illumination method (in particular, the dipole illumination method), as disclosed in Japanese Unexamined Patent Application, First Publication No. H06-188169, in which the illumination direction is aligned with the longitudinal direction of the line pattern, etc. may be appropriately combined with the above configuration, which works more effectively. In particular, the combination of the linearly polarized light illumination method and the dipole illumination method works effectively in the case where periodic directions of the line-and-space pattern are limited to a predetermined single direction, or in the case where hole patterns are densely populated along a predetermined single direction. For example, in the case where a halftone phase shift mask (a pattern with a halfpitch of about 45 nm) with a light transmittance of 6% is exposed by concurrent use of the linearly polarized light illumination method and the dipole illumination method, the depth of focus (DOF) can be increased by about 150 nm compared with the use of random-polarized light, if the value of illumination σ defined by the circumcircle of the two light fluxes forming a dipole on the pupil surface of the illumination system is set to 0.95; the radius of each light flux on the pupil surface is set to 0.125σ; and the numerical aperture of the projection optical system PL is set as NA = 1.2.

The combination of the linearly polarized light illumination method and the small σ illumination method (the illumination method in which the value σ, which shows the ratio of the numerical aperture NAi of the illumination system to the numerical aperture NAp of the projection optical system, is 0.4 or less) also works effectively.

Furthermore, for example, when by using, for example, ArF excimer laser light as the exposure light and using the projection optical system PL having a reduction magnification of about 1/4, a fine line-and-space pattern (e.g., line-and-space of about 25 to 50 nm) is exposed onto the substrate W, the mask M with some structural characteristics (e.g., the fineness of the pattern or the thickness of chrome) acts as a polarization plate due to the wave guide effect, and more of the diffraction light from S polarization components (TE polarization components) comes to be emitted from the mask M than the amount of the diffraction light from P polarization components (TM polarization components) which lower the contrast. In this case, the above-described linearly polarized light illumination is desirably employed. However, also by illuminating the mask M with random-polarized light, a high resolution performance can be obtained even in the case where the numerical aperture NA of the projection optical system PL is large, e.g., 0.9 to 1.3.

Furthermore, when a very fine line-and-space pattern on the mask M is exposed onto the substrate W, there is a possibility that the emitted amount of the diffraction lights from P polarization components (TM polarization components) becomes larger than the emitted amount of the diffraction lights from S polarization components (TE polarization components) due to the wire grid effect. However, for example, when by using ArF excimer laser light as the exposure light and using the projection optical system PL having a reduction magnification of about 1/4, a line-and-space pattern of more than 25 nm is exposed onto the substrate W, more of the diffraction light from S polarization components (TE polarization components) is emitted from the mask M than the amount of the diffraction light from P polarization components (TM polarization components). Therefore, a high resolution performance can be obtained even in the case where the numerical aperture NA of the projection optical system PL is large, e.g., 0.9 to 1.3.

Furthermore, not only the linearly polarized light illumination (S polarized light illumination) in which the longitudinal direction of the line pattern on the mask (reticle) is aligned with the polarization direction, but also the combination, as disclosed in Japanese Unexamined Patent Application, First Publication No. H06-53120, of the polarized light illumination method, in which the light used is linearly polarized in the tangential (circumpherential) directions relative to a circle, of which center is the optical axis, and an oblique entrance illumination method is effective. In particular, in the case where not only line patterns which extend in a predetermined single direction but also line patterns which extend in multiple redundant directions are included (line-and-space patterns with different periodic directions are included) in the pattern of the mask (reticle), by using, as also disclosed in Japanese Unexamined Patent Application, First Publication No. H06-53120, the polarized light illumination method, in which the lights used are linearly polarized in the tangential directions relative to a circle, of which the center is the optical axis, in combination with an orbicular zone illumination method, a high resolution performance can be obtained even in the case where the numerical aperture NA of the projection optical system is large. For example, in the case where a halftone phase shift mask (a pattern with a halfpitch of about 63 nm) with a light transmittance of 6% is illuminated by using the linearly polarized light illumination method in which the lights used are linearly polarized in the tangential directions relative to a circle, of which center is the optical axis, in combination with the orbicular zone illumination method (orbicular zone ratio of 3/4), the depth of focus (DOF) can be increased by about 250 nm compared with the use of random-polarized light, if the value of illumination σ is set to 0.95; and the numerical aperture of the projection optical system PL is set as NA = 1.00. Furthermore, in the case of a pattern with a halfpitch of about 55 nm and the numerical aperture of the projection optical system NA = 1.2, the depth of focus can be increased by about 100 nm.

In addition to the aforementioned illumination methods, application of, for example, the progressive focus exposure method as disclosed in Japanese Unexamined Patent Application, First Publication No. H04-277612 and Japanese Unexamined Patent Application, First Publication No. 2001-345245, or a multiple wavelength exposure method that obtains the similar effect of the progressive focus exposure method by use of exposure light with multiple wavelengths (for example, two wavelengths) also works effectively.

Note that the liquid LQ of this embodiment is water, but it may be a liquid other than water. For example, if the light source of the exposure light EL is an F₂ laser, this F₂ laser light will not pass through water, so the liquid LQ may be, for example, a fluorocarbon fluid such as a perfluoropolyether (PFPE) or a fluorocarbon oil that an F₂ laser is able to pass through. In this case, the part to be in contact with the liquid LQ is applied with lyophilic treatment by forming a thin film using a substance with a molecular structure that has a small polarity including fluorine. In addition, it is also possible to use, as the liquid LQ, liquids that have the transmittance with respect to the exposure light EL and whose refractive index are as high as possible and that are stable with respect to the photoresist coated on the projection optical system PL or the surface of the substrate W (for example, cedar oil). Also in this case, the surface treatment is performed in accordance with the polarity of the liquid LQ to be used.

It is to be noted that as for substrate W of each of the above-described embodiments, not only a semiconductor wafer for manufacturing a semiconductor device, but also a glass substrate for a display device, a ceramic wafer for a thin film magnetic head, or a master mask or reticle (synthetic quartz or silicon wafer), etc. can be used in an exposure apparatus.

As for exposure apparatus EX, in addition to a scan type exposure apparatus (scanning stepper) in which while synchronously moving the mask M and the substrate W, the pattern of the mask M is scan-exposed, a step-and-repeat type projection exposure apparatus (stepper) in which the pattern of the mask M is exposed at one time in the condition that the mask M and the substrate W are stationary, and the substrate W is successively moved stepwise can be used.

Moreover, as for the exposure apparatus EX, the present invention can be applied to an exposure apparatus of a method in which a reduced image of a first pattern is exposed in a batch on the substrate W by using the projection optical system (for example, a refractive projection optical system having, for example, a reduction magnification of 1/8, which does not include a reflecting element), in the state with the first pattern and the substrate W being substantially stationary. In this case, the present invention can also be applied to a stitch type batch exposure apparatus in which after the reduced image of the first pattern is exposed in a batch, a reduced image of a second pattern is exposed in a batch on the substrate W, partially overlapped on the first pattern by using the projection optical system, in the state with the second pattern and the substrate W being substantially stationary. As the stitch type exposure apparatus, a step-and-stitch type exposure apparatus in which at least two patterns are transferred onto the substrate W in a partially overlapping manner, and the substrate W is sequentially moved can be used.

Furthermore, the present invention can also be applied to a twin stage type exposure apparatus as disclosed in Japanese Unexamined Patent Application, First Publication No. H10-163099, Japanese Unexamined Patent Application, First Publication No. H10-214783, and Published Japanese Translation No. 2000-505958 of PCT International Application.

Moreover, the present invention can also be applied to an exposure apparatus furnished with a substrate stage for holding a substrate, and a measurement stage on which is mounted a reference member formed with a reference mark, and various photoelectronic sensors, as disclosed in Japanese Unexamined Patent Application, First Publication No. H11-135400.

Furthermore, in the above embodiments, an exposure apparatus in which the liquid is locally filled in the space between the projection optical system PL and the substrate W is used. However, the present invention can be also applied to a liquid immersion exposure apparatus as disclosed in Japanese Unexamined Patent Application, First Publication No. H06-124873, in which the stage holding the target exposure substrate is moved in a liquid bath.

The types of exposure apparatuses EX are not limited to exposure apparatuses for semiconductor element manufacture that expose a semiconductor element pattern onto a substrate W, but are also widely applicable to exposure apparatuses for the manufacture of liquid crystal display elements and for the manufacture of displays, and exposure apparatuses for the manufacture of thin film magnetic heads, image pickup elements (CCD), and reticles or masks.

When using a linear motor (see U.S. Patent No. 5,623,853 or U.S. Patent No. 5,528,118) in the substrate stage PST or the mask stage MST, either air-cushion type linear motor that uses an air bearing or a magnetic levitation type linear motor that uses a Lorentz force or reactance force may be used. Furthermore, the respective stages PST, MST may be the types that move along a guide or may be the guideless types in which a guide is not provided.

As the driving mechanism for the respective stages PST, MST, a planar motor in which by making a magnet unit in which magnets are two-dimensionally arranged and an armature unit in which coils are two-dimensionally arranged face each other, each of substrate stage PST and mask stage MST is driven by an electromagnetic force may be used. In this case, either one of the magnet unit and the armature unit is attached to the stage PST or the stage MST, and the other unit is attached to the moving surface side of the stage PST or the stage MST.

A reaction force generated by the movement of the substrate stage PST may be, as described in Japanese Unexamined Patent Application, First Publication No. H08-166475 (U.S. Patent No. 5,528,118), mechanically released to the floor (earth) by use of a frame member so that the force does not transmit to the projection optical system PL.

A reaction force generated by the movement of the mask stage MST may be, as described in Japanese Unexamined Patent Application, First Publication No. H08-330224 (U.S. Patent No. 5,874,820), mechanically released to the floor (earth) by use of a frame member so that the force does not transmit to the projection optical system PL.

As described above, the exposure apparatus EX of the embodiments of this application is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

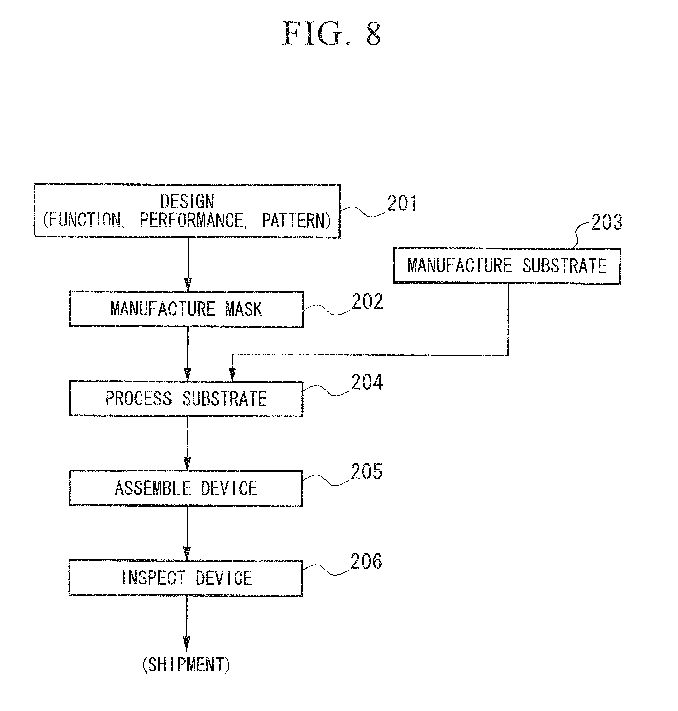

As shown in FIG. 8, microdevices such as semiconductor devices are manufactured by going through: a step 201 that performs microdevice function and performance design, a step 202 that creates the mask (reticle) based on this design step, a step 203 that manufactures the substrate that is the device base material, a step 204 having a process that exposes the pattern on the mask onto a substrate by means of the exposure apparatus EX of the above embodiments, a device assembly step (including a dicing process, a bonding process and a packaging process) 205, and an inspection step 206, and so on.

## Claims

1. An exposure apparatus that irradiates a substrate with exposure light via a projection optical system to expose the substrate, wherein
the projection optical system has a first optical element nearest to an image plane of the projection optical system and a second optical element second nearest to the image plane after the first optical element, and
the second optical element has a first surface that faces the first optical element and a second surface on the opposite side of the first surface,
the exposure apparatus comprising: an immersion mechanism that fills a first space on the first surface side of the second optical element with a liquid;
a gas supply mechanism that fills a second space on the second surface side of the second optical element with a gas; and
an adjustment mechanism that adjusts a pressure difference between a pressure of the liquid in the first space and a pressure of the gas in the second space.

2. The exposure apparatus according to claim 1, wherein the adjustment mechanism adjusts the pressure of the gas in the second space in accordance with the pressure of the liquid in the first space such that the pressure difference between the pressure of the liquid in the first space and the pressure of the gas in the second space is equal to or below a predetermined tolerance value.

3. The exposure apparatus according to claim 2, further comprising: a memory apparatus in which a relationship between the pressure difference and an imaging characteristic of the projection optical system is previously stored, wherein
the adjustment mechanism, with reference to memory information in the memory apparatus, adjusts the pressure of the gas in the second space such that a desired imaging characteristic is obtained.

4. The exposure apparatus according to claim 3, wherein the memory information includes information on an amount of deformation or movement of the second optical element in accordance with the pressure difference.

5. The exposure apparatus according to any one of claims 1 to 4, further comprising: an imaging characteristic adjustment apparatus that adjusts an imaging characteristic of the projection optical system based on the pressure difference between the pressure of the liquid in the first space and the pressure of the gas in the second space.

6. The exposure apparatus according to any one of claims 1 to 5, further comprising: an imaging characteristic adjustment apparatus that drives a specific optical element among a plurality of optical elements that constitute the projection optical system, such that a desired imaging characteristic is obtained in accordance with the pressure of the gas in the second space.

7. The exposure apparatus according to any one of claims 1 to 6, further comprising: a first detector that detects the pressure of the liquid in the first space and a second detector that detects the pressure of the gas in the second space, wherein
the adjustment mechanism adjusts the pressure of the gas in the second space based on detection results from the first and second detectors.

8. The exposure apparatus according to any one of claims 1 to 7, wherein the adjustment mechanism sets the pressure of the liquid in the first space such that an amount of fluctuation in the pressure of the liquid in the first space within a predetermined period of time falls within a predetermined range.

9. The exposure apparatus according to any one of claims 1 to 8, wherein
the immersion mechanism fills a space between the first optical element and the substrate with a liquid, and
the adjustment mechanism adjusts a pressure difference between the pressure of the liquid in the space, between the first optical element and the substrate, and the pressure of the liquid in the first space.

10. The exposure apparatus according to any one of claims 1 to 9, wherein the gas supply mechanism functions also as the adjustment mechanism.

11. The exposure apparatus according to any one of claims 1 to 10, wherein
a space between the first optical element and the substrate is also filled with a liquid, and
the substrate is irradiated with the exposure light via the liquid between the second optical element and the first optical element and via the liquid between the first optical element and the substrate to expose the substrate.

12. A device manufacturing method that uses the exposure apparatus according to any one of claims 1 to 11.

13. An exposure method that irradiates a substrate with exposure light via a projection optical system to expose the substrate, wherein
the projection optical system has a first optical element nearest to an image plane of the projection optical system and a second optical element second nearest to the image plane after the first optical element,
the second optical element has a first surface that faces the first optical element and a second surface on the opposite side of the first surface, and
the exposure method adjusting a pressure difference between a pressure of a liquid filled in a first space on the first surface side of the second optical element and a pressure of a gas filled in a second space on the second surface side of the second optical element.

14. The exposure method according to claim 13, wherein the pressure difference between the pressure of the liquid in the first space and the pressure of the gas in the second space is adjusted to be equal to or below a predetermined tolerance value.

15. The exposure method according to claim 14, wherein the pressure of the gas in the second space is adjusted in accordance with the pressure of the liquid in the first space.

16. The exposure method according to claim 13, wherein
a space between the first optical element and the substrate is also filled with a liquid, and
a pressure difference between the pressure of the liquid in the space, between the first optical element and the substrate, and the pressure of the liquid in the first space is adjusted.

17. The exposure method according to claim 13, wherein
a relationship between the pressure difference and an imaging characteristic of the projection optical system is previously acquired, and
the pressure of the gas in the second space is adjusted based on the relationship such that a desired imaging characteristic is obtained.

18. A device manufacturing method that uses the exposure method according to any one of claims 12 to 17.
